# EUROPEAN PATENT APPLICATION

(11) **EP 2 233 240 A1**
(43) Date of publication of application: **29.09.2010**
(21) Application number: 08858435.4
(22) Date of filing: 01.10.2008
(51) Int. Cl.: B23K 26/16, B23K 26/10, B23K 101/40

(54) **LASER PROCESSING MACHINE**

(30) Priority: 12.12.2007 JP 2007320629
(71) Applicant: Kataoka Corporation, Kyoto-shi Kyoto 601-8203 (JP)
(72) Inventor: MATSUMOTO, Junichi, Kyoto-shi Kyoto 601-8203 (JP)
(74) Representative: TBK-Patent
(86) International application number: PCT/JP2008/067859
(87) International publication number: WO 2009/075137

(57) **Abstract**

An intended purpose of this invention is to provide a laser processing machine which is capable of preventing a substrate from being contaminated and damaged due to roughness or burr of a table surface while efficiently collecting powdery dust produced during machining thereby suppressing scattering of the powdery dust and re-adherence of the powdery dust to a work surface of the substrate. For this purpose, a laser processing machine is provided which includes: a table 1 provided with levitating devices 2 and 3 for levitating a substrate 0 as a work; a conveyor device 4 configured to convey the substrate 0 being levitated in a predetermined direction relative to the table 1; a laser beam emitting device 5 configured to apply a laser beam to a work surface on a lower side of the substrate 0 being conveyed through a predetermined work area defined on the table 1; and a dust collection nozzle 7 disposed at the table 1 so as to open substantially immediately below a point of irradiation P with the laser beam applied to the work surface of the substrate 0.

## Description

### Technical Field

The present invention relates to a laser processing machine which performs laser scribing, patterning and the like on a thin film in a fabrication process for solar cell panels, organic EL displays or plasma displays for example.

### Background Art

A laser processing machine of this type is mainly used for removal machining by irradiating a thin film on a work surface of a substrate with a laser beam. Patent Document 1 noted below discloses a laser processing machine configured to irradiate a substrate placed on a flat table with a laser beam from above for scribing a thin film while moving the table.

With such a laser processing machine of the type configured to irradiate a substrate placed on a table with a laser beam, the table becomes burned and sooty under certain conditions of laser characteristics or through long-term use, which causes roughness or burr to take place on the table surface. Such roughness or burr of the table surface becomes a factor causing the substrate to be contaminated or flawed.

In order to avoid contamination and damage to the substrate, any matter is desirably not present in the vicinity of a point of irradiation with the laser beam. Patent Document 2 noted below discloses a laser processing machine having a measure-like hollow table with an upwardly oriented opening for supporting only the peripheral edge portion of a substrate.
Patent Document 1: Japanese Patent Laid-Open Publication No. 2003-298161
Patent Document 2: Japanese Patent Laid-Open Publication No. 2001-232486

### Disclosure of the Invention

### Problems to be solved by the Invention

Laser scribing techniques include: a technique including placing a substrate with its work surface oriented upward and directly irradiating the work surface with a laser beam; and a technique including placing a substrate with its work surface oriented downward and irradiating the work surface with a laser beam passing through the substrate. With the former, fine powdery dust resulting from scribing remains on the work surface, whereas the latter allows such powdery dust to be released and dropped from the work surface.

In cases where the latter technique is applied to the above-described laser processing machine having the measure-like hollow table, powdery dust is deposited on the bottom of the hollow table and, hence, the deposited powdery dust needs to be periodically removed by cleaning. What is more, scattered powdery dust sometimes adheres to the work surface again.

It is needless to say that inhalation of such powdery dust by an operator is not preferable.

The present invention, which has been made in view of the foregoing problems, intends to provide a laser processing machine which is capable of preventing a substrate from being contaminated and damaged due to roughness or burr of a table surface while efficiently collecting powdery dust produced during machining thereby suppressing scattering of the powdery dust and re-adherence of the powdery dust to a work surface of the substrate.

### Means for Solving the Problems

According to the present invention, a laser processing machine is constructed which comprises: a table provided with a levitating device for levitating a substrate as a work; a conveyor device configured to convey the substrate being levitated in a predetermined direction relative to the table; a laser beam emitting device configured to apply a laser beam to a work surface of the substrate being conveyed through a predetermined work area defined on the table; and a dust collection nozzle disposed in the work area so as to open adjacent a point of irradiation with the laser beam applied to the work surface of the substrate.

Such a laser processing machine is capable of efficiently collecting powdery dust produced from the work surface of the substrate. Since the opening of the dust collection nozzle is present adjacent the point of irradiation with the laser beam, that is, since any matter is not present adjacent the point of irradiation with the laser beam, contamination or damage to the substrate will not occur due to roughness or burr of the table surface.

In order for the laser processing machine to adopt the technique including placing the substrate with its work surface oriented downward and irradiating the work surface with the laser beam passing through the substrate, the dust collection nozzle is disposed so as to open substantially immediately below the point of irradiation with the laser beam applied to the work surface of the substrate.

The levitating device is configured to jet gas upwardly from below the substrate. By providing such levitating devices over an extensive area of the table to jet gas against substantially the entire area of the substrate, the substrate can be levitated without deflection even when the substrate is of a large size. This arrangement contributes to an improvement in machining precision with respect to a substrate requiring a severely limited machining depth. Since no friction takes place between the table and the substrate, there is no possibility that a heavy load is imposed locally on the work surface of the substrate to crash a portion of the thin film that lies at the load imposed portion. Further, it is possible to downsize the conveyor device configured to convey the substrate, as well as to lower the vibration level during high-speed conveyance.

In order to perform laser beam machining over substantially the entire area of the substrate, the laser beam emitting device should include a plurality of laser beam emitting devices arranged in a direction intersecting the direction of conveyance of the substrate and/or should be movable in that direction. When the dust collection nozzle is shaped into a slot extended in the direction intersecting the direction of conveyance of the substrate, the dust collection nozzle can collect powdery dust produced from different points by laser beams emitted from the laser beam emitting devices without leaving residual dust.

Preferably, the conveyor device comprises a carriage disposed on a side portion of the table which is capable of traveling while holding an edge portion of the substrate.

The laser processing machine may further comprise a jet nozzle disposed in the work area at a location adjacent to the dust collection nozzle and configured to jet gas from below the substrate in an obliquely upward direction slanted toward the dust collection nozzle. This feature makes it possible to obviate a danger that the leading or trailing edge of the substrate declines at a location adjacent the opening of the dust collection nozzle and collides with the dust collection nozzle. By increasing the flow rate of gas jetted from the jet nozzle the dust collection effect is enhanced because the gas flows into the dust collection nozzle after having lashed against the substrate to cause a negative pressure to occur under the substrate at a location adjacent the point of irradiation with the laser beam.

The jet nozzle may comprise a plurality of jet nozzles located adjacent to the dust collection nozzle on opposite sides thereof in the direction of conveyance of the substrate. This feature further enhances the effect of obviating collision of the substrate and the dust collection effect.

In order to increase the flow rate of gas jetted from the jet nozzle, the jet nozzle is preferably shaped into a slit extended in the direction intersecting the direction of conveyance of the substrate and having a narrower opening width than the dust collection nozzle.

### Advantage(s) of the Invention

According to the present invention, a laser processing machine can be realized which is capable of preventing a substrate from being contaminated and damaged due to roughness or burr of a table surface while efficiently collecting powdery dust produced during machining thereby suppressing scattering of the powdery dust and re-adherence of the powdery dust to a work surface of the substrate.

### Brief Description of the Drawings

FIG. 1 is a perspective view illustrating a laser processing machine according to one embodiment of the present invention;
FIG. 2 is a plan view of a relevant portion for illustrating a conveyor device included in the laser processing machine;
FIG. 3 is a side view of a relevant portion for illustrating a dust collection nozzle included in the laser processing machine;
FIG. 4 is a side view of a relevant portion for illustrating a dust collection nozzle and a jet nozzle in one variation of the present invention;
FIG. 5 is an enlarged side view of a relevant portion for illustrating the dust collection nozzle and the jet nozzle in the same variation;
FIG. 6 is a perspective view illustrating the dust collection nozzle and the jet nozzle in the same variation; and
FIG. 7 is a side view of a relevant portion for illustrating a dust collection nozzle and a jet nozzle in one variation of the present invention.

### Description of Reference Characters

- 0: substrate
- 1: table
- 2,3: levitating device
- 4: conveyor device (carriage)
- 5: laser beam emitting device (machining nozzle)
- 7: dust collection nozzle
- 8: jet nozzle

### Best Mode for Carrying Out the Invention

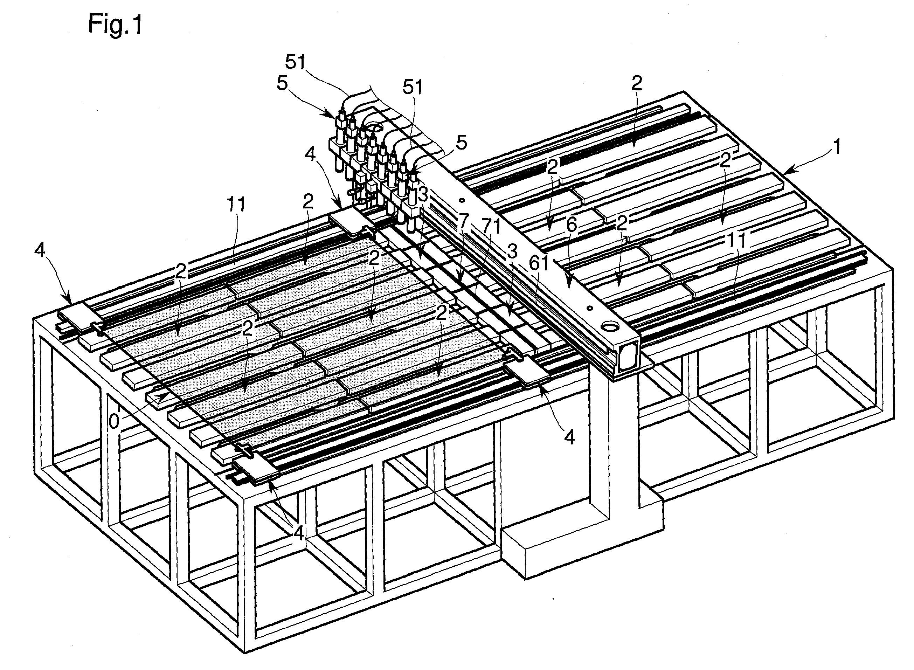

Hereinafter, one embodiment of the present invention will be described with reference to the drawings. FIG. 1 illustrates a laser processing machine according to the present embodiment. The laser processing machine illustrated includes, as major components thereof, a table 1 for supporting a substrate 0 as a work, a conveyor device 4 configured to convey the substrate 0, machining nozzles 5 as laser beam emitting devices each configured to apply a laser beam to a work surface of the substrate 0, and a dust collection nozzle 7 configured to collect powdery dust produced during laser beam machining.

The substrate 0 comprises a thin film having a photoelectric conversion ability, a transparent conductive film and a back electrode film and the like which are deposited on a surface of a glass plate, for example. The thin film is patterned with a laser beam in fabricating a thin film solar cell. The present embodiment is mainly directed to cases where the substrate 0 is placed on the table 1 to assume a position in which its work surface formed with the thin film is oriented downward.

The table 1 has a longitudinal dimension twice or more as large as that of the substrate 0 and a widthwise dimension larger than that of the substrate 0. The table 1 has a longitudinally intermediate portion defined as a work area for performing laser beam machining. Levitating devices 2 each configured to jet gas, especially air, upwardly are disposed in front and rear areas which are opposed to each other across the work area. Each of the levitating devices 2 has a top surface drilled to define innumerable jetting holes and several to innumerable inhalation holes, the jetting holes and the inhalation holes being connected to respective non-illustrated pumps or the like. The levitating devices 2 are capable of controlling the levitation height of the substrate 0 by adjusting the jet flow rate (positive pressure) of gas jetted from the jetting holes and the inhalation flow rate (negative pressure) of gas inhaled into the inhalation holes. In the present embodiment, a plurality of such levitating devices 2 are disposed over an extensive area to jet air against substantially the entire area of the substrate 0. In addition, the work area of the table 1 is provided with precision levitating devices 3 arranged densely in the widthwise direction. Although the function of the precision levitating devices 3 is similar to that of the levitating devices 2, the precision levitating devices 3 exhibit a higher precision in controlling the levitation height of the substrate 0 than the levitating devices 2. Note that the levitating devices 2 and 3 are not necessarily formed with the inhalation holes. In cases where the laser processing machine is used to perform machining requiring a not very severely limited machining depth, the levitation height control precision for the substrate 0 need not be very high and, therefore, it is possible that the levitating devices 2 and 3 have only the jetting holes.

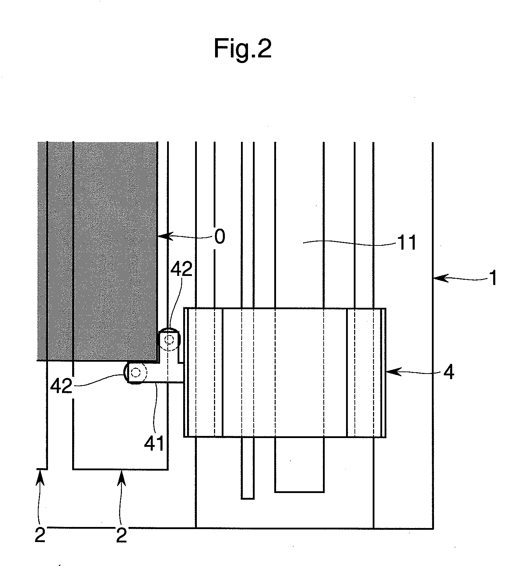

The conveyor device 4 forwardly and backwardly conveys the substrate 0 being levitated by the levitating devices 2 and 3. In the present embodiment, rails (or travel shafts) 11 are disposed to extend on opposite lateral side portions of the table 1 in which the levitating devices 2 and 3 are absent, and carriages 4 which are movable on the rails 11 are provided to convey the substrate 0. The driving source for the carriages 4 is a linear servomotor for example. As shown in FIG. 2, each of the carriages 4 is provided with a bracket 41 for gripping the substrate. The bracket 41 has an inwardly projecting L-shape in plan view and has a tip portion attached with rollers 42 which become abutted against edges of the substrate 0 to grip the substrate 0. In the example illustrated, a plurality of such carriages 4 are provided on each of opposite sides of the substrate 0 to grip the four corners, leading and trailing edges and side edges of the substrate 0. The bracket 41 of each carriage 4 can be pushed and pulled by a motor mounted on the carriage 4. The brackets 41 of the respective carriages 4 are capable of fine adjustment of the orientation of the substrate 0 by horizontally rotating the substrate 0 through their push-pull operation. The manner in which the carriages 4 support the substrate 0 is not limited to that described above. The present invention does not preclude a manner of support in which the substrate 0 is attracted by the carriages 4 or sandwiched at their edges by the carriages 4 from below and from above. The carriages 4 may be located on only one side of the substrate 0. Alternatively, it is possible that rails (or travel shafts) each extending in a gap between adjacent levitating units 2 are provided and carriages which are movable on the rails support the leading edge and/or trailing edge of the substrate 0.

The machining nozzles 5 are each configured to emit a laser beam from above the substrate 0 and irradiate the work surface, i.e., the thin film on the lower side of the substrate 0 with the laser beam passing through the substrate 0. Each of the machining nozzles 5 is connected to an optical fiber 51 to introduce laser light supplied from a non-illustrated laser oscillator through the optical fiber 51. It is possible to form an optical path for guiding the laser light to each machining nozzle 5 by using optical components such as a lens and a mirror. The machining nozzles 5 are located above the work area defined on the table 1. More specifically, a beam 6 is provided which transversely extends immediately above the work area to support the machining nozzles 5. A camera is mounted on the beam 6 to take a picture of an edge of the substrate 0 or an alignment mark provided on the substrate 0, thereby checking the orientation of the substrate 0. The brackets 41 of the carriages 4 are feedback-controlled to correct the orientation of the substrate 0 by rotation. In the present embodiment, a plurality of such machining nozzles 5 are arranged in the widthwise direction. Each of the machining nozzles 5 is movable in the widthwise direction along a rail 61 mounted on the beam 6. The driving source for the machining nozzles 5 is a linear servomotor for example.

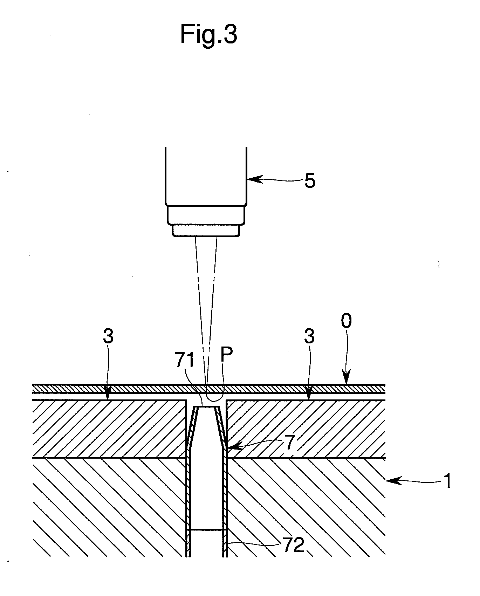

The dust collection nozzle 7 is shaped into a slot extended in the widthwise direction. The dust collection nozzle 7 is open in a gap between the longitudinally opposite precision levitating devices 3 in the work area. As illustrated in FIG. 3, the optical axis of each machining nozzle 5 extends into an opening 71 of the dust collection nozzle 7. That is, any matter is not present adjacent a point of irradiation P with the laser beam applied to the work surface of the substrate 0. The dust collection nozzle 7 is connected to a non-illustrated dust collector or the like through a duct hose 72.

With the present laser processing machine, the substrate 0 placed in the front area or the rear area of the table 1 is levitated by gas jetted from the levitating devices 2 and 3 and the carriages 4 serving as the conveyor device grip the substrate 0 thus levitated and convey it forwardly and backwardly. In the work area of the table 1 scribing is performed by applying a laser beam to the work surface of the substrate 0. Powdery dust resulting from the scribing drops from the work surface of the substrate 0 and is inhaled into the dust collection nozzle 7 and then into the duct hose 72.

According to the present embodiment, the laser processing machine is constructed which comprises: the table 1 provided with the levitating devices 2 and 3 for levitating the substrate 0 as a work; the conveyor device 4 configured to convey the substrate 0 being levitated in a predetermined direction relative to the table 1; the laser beam emitting devices 5 each configured to apply a laser beam to the work surface on the lower side of the substrate 0 being conveyed through the predetermined work area defined on the table 1; and the dust collection nozzle 7 disposed at the table 1 so as to open substantially immediately below the point of irradiation P with the laser beam applied to the work surface of the substrate 0. This construction is capable of efficiently collecting powdery dust produced from the work surface of the substrate 0 while obviating contamination and damage due to roughness or burr of the table surface that cannot be obviated by a conventional laser processing machine.

The levitating devices 2 and 3, which are configured to jet gas upwardly from below the substrate 0, are provided over an extensive area of the table 1 to jet gas against substantially the entire area of the substrate 0. Therefore, the substrate 0 can be levitated without deflection even when the substrate 0 is of a large size. This arrangement contributes to an improvement in machining precision with respect to the substrate 0 requiring a severely limited machining depth. Since no friction takes place between the table 1 and the substrate 0, there is no possibility that a heavy load is imposed locally on the work surface of the substrate 0 to crash a portion of the thin film that lies at the load imposed portion. Further, it is possible to downsize the conveyor device 4 configured to convey the substrate 0, as well as to lower the vibration level during high-speed conveyance.

Since the plurality of laser beam emitting devices 5 are arranged in a direction intersecting the direction of conveyance of the substrate 0 while the laser beam emitting devices 5 are movable in the direction intersecting the direction of conveyance of the substrate 0, substantially the entire area of the substrate 0 can be subjected to laser beam machining. Further, since the dust collection nozzle 7 is shaped into a slot extended in the direction intersecting the direction of conveyance of the substrate 0, the dust collection nozzle 7 can collect powdery dust produced from different points by laser beams emitted from the laser beam emitting devices 5 without leaving residual dust.

Since the conveyor device includes the carriages 4 each disposed on a side portion of the table 1 which are capable of traveling while holding edge portions of the substrate 0, the carriages 4 can be easily subjected to maintenance, checking and the like.

The present invention is not limited to the embodiment specifically described above. For example, though the above-described embodiment has the arrangement in which the laser light emitting devices 5 are located immediately above the dust collection nozzle 7 and each has an optical axis oriented vertically downward, it is simply required that the point of irradiation P with a laser beam applied to the work surface of the substrate 0 be located immediately above the opening 71 of the dust collection nozzle 7 even when the optical axis of each laser beam emitting device 5 is slanted. It is possible to adopt an arrangement wherein the laser beam emitting devices 5 are disposed below the substrate 0 to apply laser beams directly to the work surface of the substrate 0.

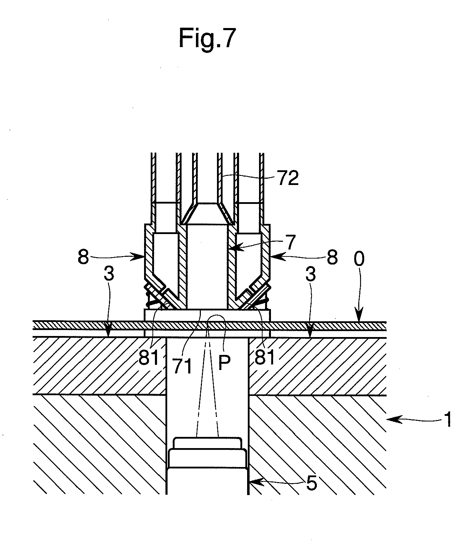

An alternative laser processing machine may be constructed in which the laser beam emitting devices 5 are disposed below the substrate 0 in the work area while the dust collection nozzle 7 disposed above the substrate 0, as illustrated in FIG. 7. With this variation, the substrate 0 is placed with its work surface oriented upward and the work surface is irradiated with a laser beam passing through the substrate 0. The dust collection nozzle 7 is supported by the table 1, beam 6 or the like so as to open substantially immediately above the point of irradiation P with the laser beam applied to the work surface of the substrate 0. The optical axis of each machining nozzle 5 extends into the opening 71 of the dust collection nozzle 7. That is, any matter is not present adjacent the point of irradiation 7 with the laser beam applied to the work surface of the substrate 0. In addition, since the dust collection nozzle 7 is located in a manner to shield laser light, it is possible to avoid a danger that the operator directly views the laser light inadvertently.

While the laser processing machine according to the above-described embodiment has the single work area in which the laser beam emitting devices 5 and the dust collection nozzle 7 are disposed, a plurality of such work areas may be provided.

In the laser processing machine according to the above-described embodiment, the plurality of laser beam emitting devices 5 are arranged in the direction intersecting the direction of conveyance of the substrate 0 and are movable in that direction. However, it is possible that a plurality of laser beam emitting devices 5 are arranged in a direction parallel with the direction of conveyance of the substrate 0 and/or are movable in that direction. The laser beam emitting devices 5 may be arranged in rows longitudinally and transversely or in a staggered fashion. In any case, the table 1 is provided with the dust collection nozzle 7 extended in the direction in which the laser beam emitting devices 5 are arranged or movable.

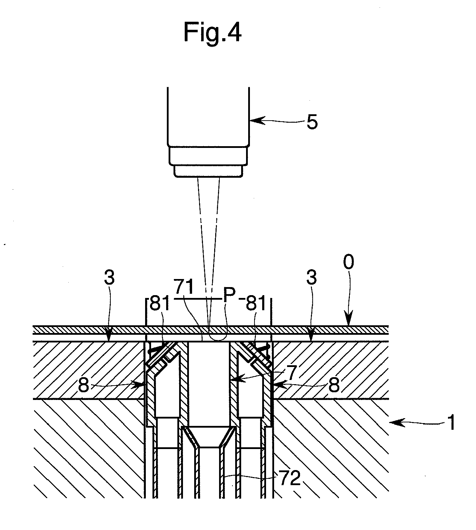

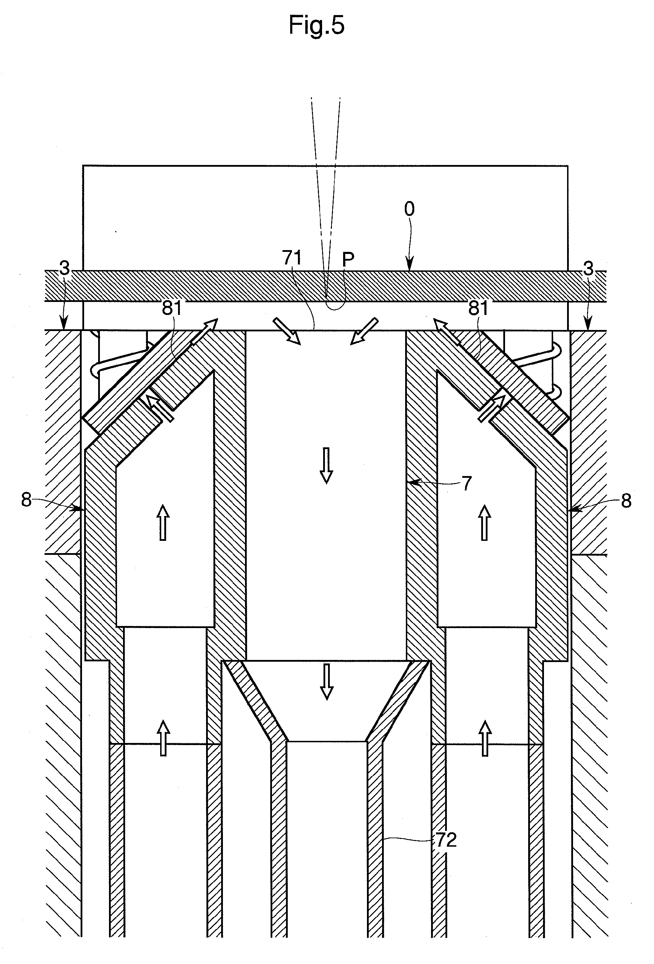

It is conceivable that the work area is provided with jet nozzles 8 disposed adjacent to the dust collection nozzle 7, as illustrated in FIGs. 4 to 7. The jet nozzles 8 are located forwardly and rearwardly of the dust collection nozzle 7 and have their jetting holes 81 oriented in directions slanted toward the dust collection nozzle 7. Each of the jet nozzles 8 is also extended in the widthwise direction. The jetting hole 81 of each jet nozzle 8 has a narrowed opening width which is far smaller than that of the dust collection nozzle 7. The jet nozzles 8 are connected to a non-illustrated pump or the like. Each jet nozzle 8 is configured to jet gas, particularly air, obliquely upward. As indicated by arrows in FIG. 5, the streams of gas jetted from the front and rear jet nozzles 8 meet each other at a location immediately below the substrate 0 and then flow into the opening 71 of the dust collection nozzle 7. Thus, an improvement can be expected to be made in dust collection effect by properly dropping powdery dust produced from the work surface of the substrate 0 into the dust collection nozzle 7. In addition, a layer (or film) of compressed gas is formed between the substrate 0 and the dust collection nozzle 7 and acts to support the substrate 0. For this reason, it is possible to prevent the occurrence of an inconvenience that the leading or trailing edge of the substrate 0 is caught by the peripheral edge of the opening of the dust collection nozzle 7.

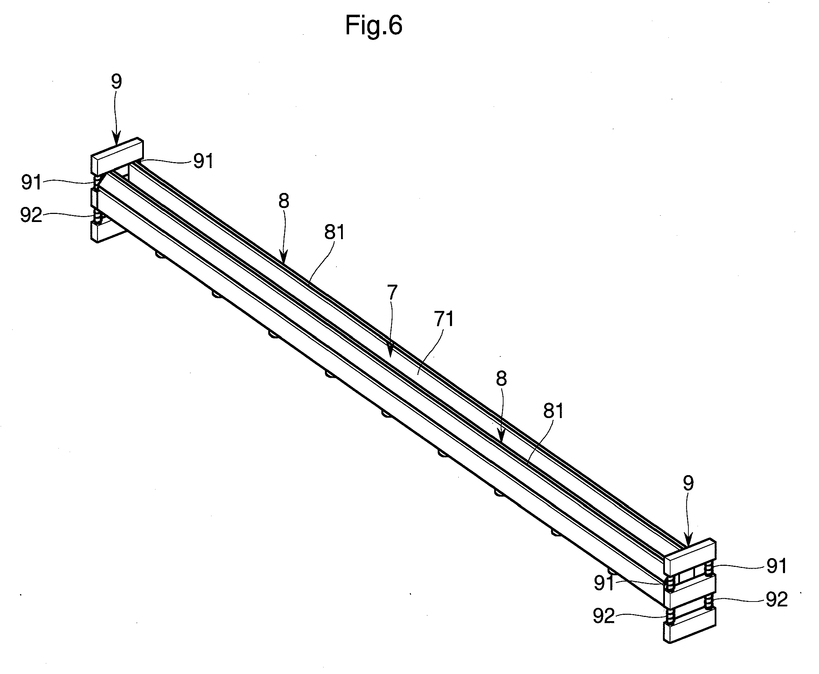

The jet nozzles 8 illustrated in FIG. 6 form a unit integral with the dust collection nozzle 7. This unit is supported on opposite sides thereof via balancers 9. Each of the balancers 9 includes both a spring 91 elastically biasing the dust collection nozzle 7 (and the jet nozzles 8) downwardly and a spring 92 biasing the dust collection nozzle 7 upwardly and serves to keep constant the spacing between the upper edge of the dust collection nozzle 7 and the work surface of the substrate 0. Note that the balancers 9 are not indispensable and the dust collection nozzle 7 and the jet nozzles 8 may be fixed.

According to the variations illustrated in FIGs. 4 to 7, the table 1 is further provided with the jet nozzles 8 which are disposed adjacent to the dust collection nozzle 7 and are each configured to jet gas from below the substrate 0 in an obliquely upward direction slanted toward the dust collection nozzle 7. This feature makes it possible to obviate a danger that the leading or trailing edge of the substrate 0 declines at a location adjacent the opening 71 of the dust collection nozzle 7 and collides with the dust collection nozzle 7. In addition, by increasing the flow rate of gas jetted from the jet nozzles 8 the dust collection effect is enhanced because the jetted gas flows into the dust collection nozzle 7 after having lashed against the substrate 0 to cause a negative pressure to occur under the substrate 0 at a location adjacent the point of irradiation 8 with a laser beam. An effect exercised depending on the kind of gas jetted from the jet nozzles 8 can be added in machining the substrate 0. For example, when O₂ gas is jetted, oxidation of the thin film can be facilitated, whereas when inert gas, such as N₂ gas, is jetted, oxidation of the thin film can be suppressed.

Since the jet nozzles 8 are disposed adjacent to the dust collection nozzle 7 on opposite sides thereof in the direction of conveyance of the substrate 0, the effect of obviating collision of the substrate 0 and the dust collection effect can be enhanced further.

Since the jet nozzles 8 are each shaped into a slit which is extended in the direction intersecting the direction of conveyance of the substrate 0 and has a narrower opening width than the dust collection nozzle 7, the flow rate of gas jetted from each jet nozzle 8 can be increased effectively.

Other specific components and features may be varied variously without departing from the concept of the present invention.

### Industrial Applicability

The laser processing machine according to the present invention is capable of preventing a substrate from being contaminated and damaged due to roughness or burr of a table surface while efficiently collecting powdery dust produced during laser beam machining thereby suppressing scattering of the powdery dust and re-adherence of the powdery dust to a work surface of the substrate.

## Claims

1. A laser processing machine comprising:
a table provided with a levitating device for levitating a substrate as a work;
a conveyor device configured to convey the substrate being levitated in a predetermined direction relative to the table;
a laser beam emitting device configured to apply a laser beam to a work surface of the substrate being conveyed through a predetermined work area defined on the table by the conveyor device; and
a dust collection nozzle disposed in the work area so as to open adjacent a point of irradiation with the laser beam applied to the work surface of the substrate.

2. A laser processing machine comprising:
a table provided with levitating devices for levitating a substrate as a work by jetting gas upwardly from below the substrate;
a conveyor device configured to convey the substrate being levitated in a predetermined direction relative to the table and the levitating devices;
a laser beam emitting device configured to apply a laser beam to a work surface of the substrate being conveyed through a predetermined work area defined on the table by the conveyor device; and
a dust collection nozzle disposed in the work area so as to open adjacent a point of irradiation with the laser beam applied to the work surface of the substrate, wherein
the levitating devices are located in front and rear areas which are opposed to each other across the work area in the direction of conveyance of the substrate, whereby the laser emitting device is allowed to apply the laser beam to the work surface of the substrate being conveyed through the work area of the table as levitated by the levitating devices.

3. The laser processing machine according to claim 1, wherein:
the work surface is positioned on a lower side of the substrate; and
the dust collection nozzle is disposed so as to open substantially immediately below the point of irradiation with the laser beam applied to the work surface of the substrate.

4. The laser processing machine according to claim 3, further comprising a jet nozzle disposed in the work area at a location adjacent to the dust collection nozzle and configured to jet gas from below the substrate in an obliquely upward direction slanted toward the dust collection nozzle.

5. The laser processing machine according to claim 4, wherein the jet nozzle comprises a plurality of jet nozzles located adjacent to the dust collection nozzle on opposite sides thereof in the direction of conveyance of the substrate.

6. The laser processing machine according to claim 4, wherein:
the dust collection nozzle is shaped into a slot extended in a direction intersecting the direction of conveyance of the substrate; and
the jet nozzle is shaped into a slit extended in the direction intersecting the direction of conveyance of the substrate and having a narrower opening width than the dust collection nozzle.

7. The laser processing machine according to claim 1, wherein the levitating device is configured to jet gas upwardly from below the substrate.

8. The laser processing machine according to claim 1, wherein:
the dust collection nozzle is shaped into a slot extended in a direction intersecting the direction of conveyance of the substrate; and
the laser beam emitting device comprises a plurality of laser beam emitting devices arranged in the direction in which the dust collection nozzle is extended.

9. The laser processing machine according to claim 1, wherein:
the dust collection nozzle is shaped into a slot extended in a direction intersecting the direction of conveyance of the substrate; and
the laser beam emitting device is movable in the direction in which the dust collection nozzle is extended.

10. The laser processing machine according to claim 1, wherein the conveyor device comprises a carriage disposed on a side portion of the table which is capable of traveling while holding an edge portion of the substrate.

11. The laser processing machine according to claim 1, wherein the table has a longitudinal dimension twice or more as large as that of the substrate as the work.
